# EUROPÄISCHE PATENTSCHRIFT

(11) **EP 3 865 890 B1**
(45) Veröffentlichungstag und Bekanntmachung des Hinweises auf die Patenterteilung: **24.05.2023**
(21) Anmeldenummer: 20157178.3
(22) Anmeldetag: 13.02.2020
(51) Int. Cl.: G01R 33/44, G01R 33/422

(54) **MAGNETRESONANZTOMOGRAPH MIT B0-MODULATION UND VERFAHREN ZUM BETRIEB**
MAGNETIC RESONANCE TOMOGRAPH WITH B0 MODULATION AND METHOD OF OPERATION
TOMOGRAPHE À RÉSONANCE MAGNÉTIQUE À MODULATION B0 ET PROCÉDÉ DE FONCTIONNEMENT

(43) Veröffentlichungstag der Anmeldung: 18.08.2021
(73) Patentinhaber: Siemens Healthcare GmbH, 91052 Erlangen (DE)
(72) Erfinder: Biber, Stephan, 91056 Erlangen (DE); Vester, Markus, 90471 Nürnberg (DE)

(56) Entgegenhaltungen:
- EP-A1- 3 591 420
- WO-A1-2016/173861
- US-A1- 2008 048 658
- US-A1- 2017 293 005
- JAMU K ALFORD ET AL: "Design and Construction of a Prototype High-Power Bo Insert Coil for Field-Cycled Imaging in Superconducting MRI Systems", CONCEPTS IN MAGNETIC RESONANCE PART A, JOHN WILEY & SONS, INC, US, Bd. 35B, Nr. 1, 12. Februar 2009 (2009-02-12), Seiten 1-10, XP008141069, ISSN: 1546-6086, DOI: 10.1002/CMR.B.20132
- "MAGNETIC RESONANCE IMAGING (MRI) SYSTEM WITH MINI RADIO FREQUENCY (RF) SHIELDING ROOM", IP.COM, IP.COM INC., WEST HENRIETTA, NY, US, 22. April 2010 (2010-04-22), XP013137933, ISSN: 1533-0001

## Beschreibung

Die Erfindung betrifft einen Magnetresonanztomographen mit ein Magneteinrichtung, die eine Magnetsteuerung aufweist, die ausgelegt ist, in einem Messvolumen ein homogenes Magnetfeld B0 mit einer zwischen einem ersten vorbestimmten Wert und einem zweiten vorbestimmten Wert veränderbaren Magnetfeldstärke in einer kurzen vorbestimmten Zeit von dem Magnetresonanztomographen gesteuert zu ändern.

Magnetresonanztomographen sind bildgebende Vorrichtungen, die zur Abbildung eines Untersuchungsobjektes Kernspins des Untersuchungsobjektes mit einem starken äußeren Magnetfeld ausrichten und durch ein magnetisches Wechselfeld zur Präzession um diese Ausrichtung anregen. Die Präzession bzw. Rückkehr der Spins aus diesem angeregten in einen Zustand mit geringerer Energie wiederum erzeugt als Antwort ein magnetisches Wechselfeld, das über Antennen empfangen wird.

Mit Hilfe von magnetischen Gradientenfeldern wird den Signalen eine Ortskodierung aufgeprägt, die nachfolgend eine Zuordnung von dem empfangenen Signal zu einem Volumenelement ermöglicht. Das empfangene Signal wird dann ausgewertet und eine dreidimensionale bildgebende Darstellung des Untersuchungsobjektes bereitgestellt. Zum Empfang des Signals werden vorzugsweise lokale Empfangsantennen, sogenannte Lokalspulen verwendet, die zur Erzielung eines besseren Signal-Rauschabstandes unmittelbar am Untersuchungsobjekt angeordnet werden. Die Empfangsantennen können auch in einer Patientenliege verbaut sein.

Magnetresonanztomographen erfordern in zweierlei Hinsicht eine Hochfrequenzabschirmung. Zum einen werden zur Anregung der Kernspins Hochfrequenzimpulse mit Leistungen im Kilowattbereich erzeugt, die nur teilweise im Patienten absorbiert werden. Radiowellen, die die Patientendurchführung verlassen, werden in den Raum abgestrahlt und müssen daher zur Einhaltung von Emissionsgrenzwerten abgeschirmt werden.

Umgekehrt sind die für die Bildgebung zu empfangenden Magnetresonanzsignale extrem schwach. Um hier ein ausreichendes Signal-zu-Rausch-Verhältnis (SNR) zu erreichen, ist eine Abschirmung externer Störsignal erforderlich.

Deshalb werden im Stand der Technik um einen Magnetresonanztomographen aufwändige Schirmkabinen installiert, um sowohl Emissionen als auch Immissionen zu reduzieren.

Die Druckschrift US 2017/293005 A1 beschreibt ein Delta-Relaxations-Magnetresonanzsystem. Das System weist einen Feldmagneten und Spulen zur Feldstärkeveränderung auf. Das BO-Feld des Feldmagneten kann durch die Spulen verändert werden. Das Delta-Relaxations-Magnetresonanzsystem kann genutzt werden, um eine Signalerfassung einer T2*-gewichteten Abbildung, einer MR-Spektroskopie, einer Sättigungs-Aufnahme oder für Finger-Printing vorzunehmen. Das Magnetresonanzsignal kann verbessert werden, indem die Magnetfeldstärke B0 während zumindest eines Teils der Pulssequenz variiert wird.

Aus dem Dokument US 2008/048658 A1 ist ein Signalverarbeitungssystem zur aktiven Unterdrückung von Störungen aus der Umgebung bekannt. Das System verwendet eine Störerfassungsspule außerhalb des Bilderfassungsvolumens, um ein Umgebungssignal zu erfassen. Es zieht die korrelierte Störung in dem Umgebungssignal von dem Magnetresonanzsignal ab. Die Störunterdrückung ermöglicht den Verzicht auf eine Hochfrequenzabschirmung.

Die Druckschrift WO 2016/173861 A1 beschreibt ein Verfahren zur Unterdrückung von Umgebungsstörungen bei einem Magnetresonanzsystem mit einer Empfangsantenne. Das Verfahren umfasst das Erfassen von Magnetresonanzsignalen mit einem Störsignalanteil mit einer Antenne und das Erfassen eines Störsignals, das Umgebungsstörungen angibt. Weiterhin erfolgt ein Berechnen eines Kompensationsfaktors auf Basis des Störsignals und eines Teils der Magnetresonanzdaten, der auf Daten am Rand des k-Raums beschränkt ist, und ein Abschätzen des Störsignalanteils in den MR-Daten als Produkt der Störsignaldaten mal dem Kompensationsfaktor. Schließlich werden korrigierte MR-Daten erzeugt, indem der abgeschätzte Störsignalanteil von den MR-Daten subtrahiert wird.

Es ist deshalb eine Aufgabe der Erfindung, den Aufwand für eine Schirmung zu reduzieren.

Die Aufgabe wird durch einen erfindungsgemäßen Magnetresonanztomographen nach Ansprüchen 1 und 2 sowie ein erfindungsgemäßes Verfahren zum Betrieb des Magnetresonanztomographen nach Ansprüchen 6 und 7 gelöst.

Der erfindungsgemäße Magnetresonanztomograph weist eine Magneteinrichtung mit einer Magnetsteuerung auf. Die Magneteinrichtung ist durch Magnetspulen ausgelegt, in einem Messvolumen ein homogenes Magnetfeld B0 zu erzeugen. Das Messvolumen ist dabei das Volumen, in dem die Larmorfrequenz L1 der zu erfassenden Kernspins bei dem ersten homogenen Magnetfeld B01 mit der Frequenz eines Anregungspulse eines magnetischen Wechselfeldes B1 übereinstimmt, sodass die zu erfassenden Kernspins in dem Messvolumen angeregt werden. Das Magnetfeld in dem Messvolumen, in dem durch den Anregungspuls mit der Frequenz L1 die zu erfassenden Kernspins angeregt werden, wird dabei im Sinne der Erfindung als homogen angesehen. Das Messvolumen ist dabei eine Teilmenge des als Field of View Volumens, in dem grundsätzlich eine Bilderfassung mit dem Magnetresonanztomographen möglich ist. Das Field of View wird beispielsweise durch Homogenitätsanforderungen an das durch einen Feldmagneten der Magneteinrichtung erzeugte statische homogene Magnetfeld B0, die Homogenität der Gradientenfelder und des magnetischen Wechselfeldes B1 zur Anregung der Kernspins definiert, indem gewisse Variationen in dem Volumen des Field of View nicht überschritten werden dürfen.

Das Messvolumen ist dabei beispielsweise eine Schicht, für die Kernspins gleichzeitig erfasst werden sollen. Die Selektion der Schicht wird dabei durch Überlagerung eines über ein ganze Field of View räumlich homogenen Magnetfeldes B0 mit einem Gradientenfeld Gz erzielt. Die Selektion kann bei der Anregung und/oder dem Empfangen der Magnetresonanzsignale erfolgen.

Die Magneteinrichtung ist mittels der Magnetsteuerung ausgelegt, das homogene Magnetfeld in dem Messvolumen zwischen dem ersten vorbestimmten Wert der Magnetfeldstärke B01 bei dem Anregen der Kernspins und einem zweiten vorbestimmten Wert der Magnetfeldstärke B02 beim Empfangen von Magnetresonanzsignalen der angeregten zu erfassenden Kernspins in einer kurzen vorbestimmten Zeit von dem Magnetresonanztomographen gesteuert zu ändern. Als kurz wird dabei ein Zeitraum kleiner der Dauer einer Sequenz, insbesondere kleiner als der zeitliche Abstand eines Anregungspulses zu dem nachfolgenden Empfangen der Magnetresonanzsignale betrachtet. Der Zeitraum ist vorzugsweise kleiner als 50 ms, 10 ms oder 1 ms. Mit anderen Worten, die durch den Anregungspuls mit einer Frequenz L1 bei dem Magnetfeld B01 angeregten Kernspins senden während des Empfangens die Magnetresonanzsignale auf einer veränderten Frequenz L2, die durch das veränderte Magnetfeld B02 bestimmt ist und werden auch auf dieser Frequenz von dem Empfänger aufgenommen.

In dem erfindungsgemäßen Verfahren wird in einem Schritt in dem Messvolumen ein erstes Magnetfelde B01 durch die Magneteinrichtung eingestellt und in einem weiteren Schritt die zu erfassenden Kernspins in dem Messvolumen mittels des magnetischen Wechselfeldes B1 mit der Frequenz L1 durch den Sender in dem ersten homogenen Magnetfeld B01 angeregt.

In einem weiteren Schritt wird ein zweites homogenes Magnetfeld B02 durch die Magneteinrichtung in dem Messvolumen eingestellt, das sich durch die Magnetfeldstärke von dem ersten homogenen Magnetfeld B01 unterscheidet und mittels des Empfängers das Magnetresonanzsignal der Kernspins aus dem Messvolumen empfangen.

Die Magnetfeldstärke des homogenen Magnetfeldes B01 kann sich dabei beispielsweise um mehr als 0,1, 1 oder 10 Promille von der Magnetfeldstärke des homogenen Magnetfeldes B02 unterscheiden, beispielsweise um mehr als 1 mT, 5 mT, 10 mT oder 50mT. Die Verschiebung der Larmorfrequenz durch das veränderte Magnetfeld B02 gegenüber B01 kann beispielsweise mehr als 10 kHz, 100 kHz, 500 kHz oder 1 MHz betragen.

Dabei ist es denkbar, dass das homogene Magnetfeld in dem Messvolumen nur über einen Zeitraum des Anregens der Kernspins auf die erste Magnetfeldstärke B01 oder nur über einen Zeitraum des Auslesens auf die zweite Magnetfeldstärke B02 geändert ist. Auf diese Weise kann ein Energieaufwand für die Feldänderung und eine Auswirkung auf die übrige Sequenz minimiert werden.

Auf vorteilhafte Weise ist es durch die Veränderung des Magnetfeldes B0 zwischen Anregen und Empfangen möglich, beide Vorgänge in unterschiedlichen Frequenzbereichen vorzunehmen und so Störungen in dem Sendefrequenzbereich von dem auf Störungen empfindlichen Empfang im Frequenzraum zu trennen und zu filtern.

Dabei liegt eine Larmorfrequenz eines zu untersuchenden Kernspins bei dem ersten Wert der Magnetfeldstärke des ersten homogenen Magnetfeldes B01 in dem Messvolumen in einem ISM-Band und bei dem zweiten Wert der Magnetfeldstärke des zweiten homogenen Magnetfeldes B02 in dem Messvolumen außerhalb des ISM-Bandes.

Als Industrieband werden für eine Nutzung durch medizinische oder technische Geräte freigegebene Frequenzbänder bezeichnet, für die erleichterte Vorschriften bei der Emission und Genehmigung vorliegen. Diese werden auch als ISM-Bänder (Industrial, Scientific, Medical Band) bezeichnet. Ein beispielhaftes Frequenzband, in dem auch mit großen Leistungen emittiert werden darf, liegt zwischen 26.9 und 27,3 MHz. Andere derartige Frequenzbänder liegen zwischen 6,7 MHz und 6,8 MHz, 13,5 MHz und 13,6 MHz, 40,6 MHz und 40,7 MHz sowie 433,0 MHz und 434,8 MHz

In einem ISM-Band gelten für Emissionen vorteilhafter Weise weniger enge Grenzwerte, sodass die Einhaltung während des Anregungspulses auch ohne Schirmung denkbar ist. Während des Empfangs ist dann das Magnetresonanzsignal aufgrund des geänderten Magnetfeldes B02 außerhalb des ISM-Bandes und damit geringeren Störungen, geg. Falls auch ohne Abschirmung, ausgesetzt.

Vorzugsweise liegt dabei die Larmorfrequenz bei der zweiten Magnetfeldstärke nur wenig außerhalb des ISM-Bandes, beispielsweise um weniger als 0,1%, 1%, 5% oder 10% oder um weniger als 100 kHz, 1 MHz oder 5MHz, sodass die Magnetfeldänderung nur gering ausfällt und mit weniger Aufwand realisierbar ist. Gleichzeitig sind dann auch geringere Änderungen am Empfänger erforderlich.

Alternativ ist die Magnetsteuerung ausgelegt, das homogene Magnetfeld B0 in der Magnetfeldstärke mit einem Code zu modulieren, um das Magnetresonanzsignal im Frequenzraum aufzuspreizen. Beispielsweise kann eine resistive Magnetspule zusammen mit einem Permanentmagneten oder einem supraleitenden Magneten genutzt werden, um einem starken statischen BO-Feld eine schnell wechselnde Komponente homogen im Messvolumen oder im ganzen Field of View zu überlagern, wenn diese mit einem Wechselstrom gespeist wird. Die Frequenz kann dabei von einigen Hertz bis zu Kilo-Hertz oder MegaHertz reichen. Das Magnetresonanzsignal erfährt dabei eine Modulation durch die variierende Larmorfrequenz in dem resultierenden Magnetfeld und wird auf durch das Modulationssignal determinierte Weise im Frequenzraum aufgespreizt und nimmt dabei eine zweite, dritte ober beliebig viele unterschiedliche Werte der Magnetfeldstärke für das homogene Magnetfeld B03, B04 ... B0n an. Denkbar sind beispielsweise auch Spread-Spectrum-Modulationen bzw. die Modulation mit Pseudo-Zufallsfolgen

Auf vorteilhafte Weise wird so verhindert, dass das Magnetresonanzsignal durch eine schmalbandige Störung völlig oder weitestgehend überdeckt wird.

Weitere vorteilhafte Ausführungsformen sind in den abhängigen Ansprüchen angegeben.

In einer möglichen Ausführungsform des erfindungsgemäßen Magnetresonanztomographen weist der Magnetresonanztomograph einen Sensor zum Empfang eines Störsignals und eine aktive Störunterdrückung zum Reduzieren eines Störsignalanteils in einem empfangenen Magnetresonanzsignal in Abhängigkeit von dem empfangenen Störsignal auf. Beispielsweise ist es denkbar, dass Störsignale mit einer Antenne aufgenommen und mit adaptiver Skalierung und Phasenverschiebung zu den empfangenen Magnetresonanzsignalen addiert werden, um durch destruktive Interferenz die Störsignalanteile im Magnetresonanzsignal auf vorteilhafte Weise zu reduzieren.

In einer denkbaren Ausführungsform des erfindungsgemäßen Magnetresonanzvorrichtung weist die Magneteinrichtung einen supraleitenden Magneten zum Erzeugen eines statischen Magnetfeldanteils aufweist und eine resistive Spulenwicklung zum Erzeugen eines dynamischen Magnetfeldanteils zur Modulation auf. Die resistive Spulenwicklung ist dabei vorzugsweise ausgelegt, im ganzen Field of View die Magnetfeldstärke des statischen Magnetfeldes B0 des supraleitenden Magneten homogen zu verändern, d.h. mit im Rahmen der für das BO-Feld üblicherweise erforderlichen Genauigkeit von wenigen ppm. Denkbar ist es aber auch, dass die Änderung der Magnetfeldstärke nur im Messvolumen homogen erfolgt. Die resistive Spulenwicklung unterscheidet sich dadurch insbesondere von den Gradientenspulen, die eine Inhomogenität herbeiführen sollen, und Shim-Spulen, die durch lokale Wirkung zum Ausgleich von Inhomogenität genutzt werden. Darüber hinaus sind die Shim-Spulen nicht für kurzfristige Änderungen der Magnetfeldstärke ausgelegt, beispielsweise aufgrund einer trägen Ansteuerung. Denkbar ist auch die Kombination eines Permanentmagneten mit einer resistiven Magnetspule.

Auf vorteilhafte Weise ermöglicht eine resistive Spule eine kurzfristige und schnelle Modulation des durch die supraleitende Spule oder einen Permanentmagneten erzeugten homogenen B0-Feldes.

In einer denkbaren Ausführungsform des erfindungsgemäßen Magnetresonanztomographen weist der Magnetresonanztomograph einen Empfänger mit einer Decodiervorrichtung auf. Die Decodiervorrichtung ist ausgelegt, aus dem durch die Modulation des Magnetfeldes B0 mit dem Code verursachte Frequenzaufspreizung aufgespreizten Magnetresonanzsignal Messpunkte im k-Raum in Abhängigkeit von dem Code zu bestimmen. Es wäre beispielsweise denkbar, das ursprüngliche Magnetresonanzsignal wieder mittels des Codes aus dem aufgespreizten Signal zu rekonstruieren. Bei einem einfachen Code aus einem Sinussignal entspricht die Frequenzspreizung einer einfachen Frequenz-Modulation mit einer Trägerfrequenz, die Rekonstruktion entspricht dann einer Demodulation des modulierten Signals. Je nach verwendetem Code erfolgt die Rekonstruktion mit einem komplementären Demodulations- bzw. Decodier-Verfahren. Für komplexere Codes wie PseudozufallsFolgen sind auch Autokorrelationsverfahren denkbar. Vorzugsweise erfolgen vor der Decodierung noch ein Entfernen bzw. Filtern des Störsignals.

Denkbar wäre es aber auch, dass die Decodier-Vorrichtung die k-Raum-Punkte direkt mit einem modifizierten Bildrekonstruktions-Verfahren anstelle der FourierTransformation aus dem empfangenen Frequenzgespreizten Signal ermittelt.

Das erfindungsgemäße Verfahren teilt die Vorteile der erfindungsgemäßen Vorrichtung.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Es zeigen:
- Fig. 1: eine schematische Darstellung eines erfindungsgemäßen Magnetresonanztomographen;
- Fig. 2: eine schematische Darstellung für eine beispielhafte Ausführungsform spezifischer Komponenten;
- Fig. 3: eine schematische Darstellung für eine beispielhafte Ausführungsform spezifischer Komponenten;
- Fig. 4: ein schematisches Ablaufdiagramm für ein beispielhaftes erfindungsgemäßes Verfahren.

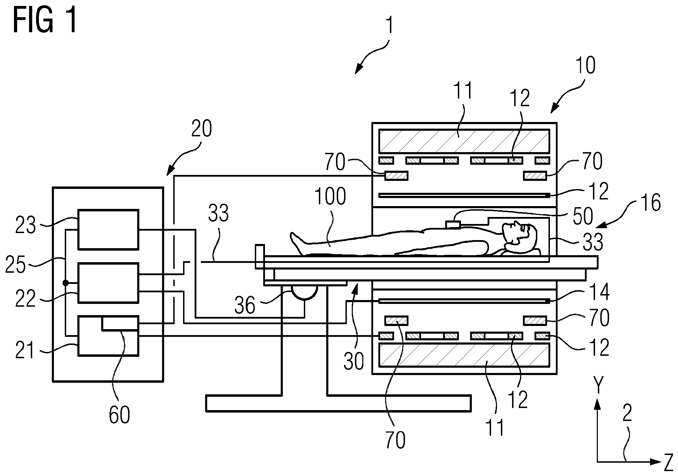

Fig. 1 zeigt eine schematische Darstellung einer Ausführungsform eines erfindungsgemäßen Magnetresonanztomographen 1.

Die Magneteinheit 10 weist einen Feldmagneten 11 auf, der ein statisches Magnetfeld B0 zur Ausrichtung von Kernspins von Proben bzw. des Patienten 100 in einem Aufnahmebereich erzeugt. Der Aufnahmebereich zeichnet sich durch ein äußerst homogenes statisches Magnetfeld B0 aus, wobei die Homogenität insbesondere die Magnetfeldstärke bzw. den Betrag betrifft. Der Aufnahmebereich ist nahezu kugelförmig und in einem Patiententunnel 16 angeordnet, der sich in einer Längsrichtung 2 durch die Magneteinheit 10 erstreckt. Eine Patientenliege 30 ist in dem Patiententunnel 16 von der Verfahreinheit 36 bewegbar. Üblicherweise handelt es sich bei dem Feldmagneten 11 um einen supraleitenden Magneten, der magnetische Felder mit einer magnetischen Flussdichte von bis zu 3T, bei neuesten Geräten sogar darüber, bereitstellen kann. Für geringere Magnetfeldstärken können jedoch auch Permanentmagnete oder Elektromagnete mit normalleitenden Spulen Verwendung finden.

Weiterhin weist die Magneteinheit 10 Gradientenspulen 12 auf, die dazu ausgelegt sind, zur räumlichen Differenzierung der erfassten Abbildungsbereiche in dem Untersuchungsvolumen dem Magnetfeld B0 zeitlich und räumlich variable Magnetfelder in drei Raumrichtungen zu überlagern. Die Gradientenspulen 12 sind üblicherweise Spulen aus normalleitenden Drähten, die zueinander orthogonale Felder in dem Untersuchungsvolumen erzeugen können.

Die Magneteinheit 10 weist ebenfalls eine Körperspule 14 auf, die dazu ausgelegt ist, ein über eine Signalleitung zugeführtes Hochfrequenzsignal in das Untersuchungsvolumen abzustrahlen und von dem Patient 100 emittierte Resonanzsignale zu empfangen und über eine Signalleitung abzugeben.

Eine Steuereinheit 20 versorgt die Magneteinheit 10 mit den verschiedenen Signalen für die Gradientenspulen 12 und die Körperspule 14 und wertet die empfangenen Signale aus.

So weist die Steuereinheit 20 eine Gradientenansteuerung 21 auf, die dazu ausgelegt ist, die Gradientenspulen 12 über Zuleitungen mit variablen Strömen zu versorgen, welche zeitlich koordiniert die erwünschten Gradientenfelder in dem Untersuchungsvolumen bereitstellen.

Weiterhin weist die Steuereinheit 20 eine Hochfrequenzeinheit 22 auf, die ausgelegt ist, einen Hochfrequenz-Puls mit einem vorgegebenen zeitlichen Verlauf, Amplitude und spektraler Leistungsverteilung zur Anregung einer Magnetresonanz der Kernspins in dem Patienten 100 zu erzeugen. Dabei können Pulsleistungen im Bereich von Kilowatt erreicht werden. Die Anregungspulse können über die Körperspule 14 oder auch über eine lokale Sendeantenne in den Patienten 100 abgestrahlt werden.

Eine Steuerung 23 kommuniziert über einen Signalbus 25 mit der Gradientensteuerung 21 und der Hochfrequenzeinheit 22.

Auf dem Patienten 100 ist eine Lokalspule 50 angeordnet, die über eine Anschlussleitung 33 mit der Hochfrequenzeinheit 22 und deren Empfänger verbunden ist.

In der Fig. 1 ist weiterhin die Magnetsteuerung 60 zur Veränderung des homogenen Magnetfeldes B0 als Teil der Gradientensteuerung 21 angegeben, kann aber auch völlig getrennt von dieser ausgeführt sein. Von der Magnetsteuerung 60 werden zwei Modulationsspulen 70 versorgt, die in Art eines Helmholtz-Spulenpaares axial um die z-Achse durch die Mitte des Patiententunnels 16 angeordnet sind. Werden beide Modulationsspulen 70 von der Magnetsteuerung 70 mit einem Strom in gleicher Flussrichtung bezüglich der Windung bzw. Drehsinn um die z-Achse angesteuert, so erzeugen sie ein homogenes Magnetfeld im Aufnahmebereich oder zumindest einem Teil davon, der in einer Messung erfasst werden soll, und im Folgenden auch als Messvolumen bezeichnet wird. Das erzeugte homogene Magnetfeld der Modulationsspulen 70 ist dem Magnetfeld des supraleitenden Feldmagneten 11 überlagert und erzeugt mit diesem gemeinsam ein veränderliches homogenes B0-Feld.

Grundsätzlich ist es im Rahmen der Erfindung auch denkbar, die Gradientenspulen 12 paarweise, d.h. das gegenüber liegenden Gx-Spulenpaar, Gy-Spulenpaar oder Gz-Spulenpaar zu einer homogenen Veränderung der Magnetfeldstärke des homogenen Magnetfeldes B0 zu nutzen. Dazu muss jedoch die Gradientensteuerung 21 als Magnetsteuerung 60 mit unabhängigen Treibern für beide Magnetspulen eines Paares ausgestattet sein, um in beiden Spulen des Paares einen gleichsinnigen Gleichstromanteil zu erzeugen. Mit anderen Worten, betrachtet man den Strom durch die Spulen als Vektor, wobei bei gleicher Stromrichtung die Spulen eines Paares Magnetfelder mit entgegengesetzter Richtung in einem Messvolumen erzeugen, so sind die Spulen eines Paares bei der Verwendung als Gradientenspule so verschaltet, dass der Strom durch die erste Spule gerade gegensinnig zur Stromrichtung der zweite Spule des Paares fließt. Bei einer Addition der Ströme mit Vorzeichen haben dann beide beim Einsatz als Gradientenspule entgegengesetztes Vorzeichen und heben sich gerade auf, sodass sich die erzeugten Magnetfelder entsprechend in der Symmetrieebene zwischen den Spulen des Paares ebenfalls aufheben. Beim erfindungsgemäßen Einsatz hingegen addieren sich die Magnetfelder der beiden Spulen zu einem von Null verschiedenen Anteil, der eben die Magnetfeldstärke des homogenen Magnetfeldes über das Messvolumen oder den ganzen Aufnahmebereich konstant verändert. Dies lässt sich beispielsweise durch separate Leistungsstufen zur Erzeugung der Ströme für jede einzelne Spule eines Paares erzielen, wobei die Magnetsteuerung 60 ausgelegt ist, beide mit einem gleichsinnigen Gleichstromanteil zum Erzeugen des homogenen Magnetfeldes zu speisen.

Überlagert sind je nach Sequenz zeitweise die Gradientenfelder, wie es auch im Stand der Technik für die unterschiedlichen Sequenzen üblich ist.

Erfindungsgemäß ist aber der homogene Anteil des Magnetfeldes B0 durch die Magnetsteuerung 60 mit den Modulationsspulen 70 in Synchronisation mit der Sequenz über die Steuerung 23 zwischen Anregung der Kernspins und Empfang durch das veränderte homogene Magnetfeld verändert, sodass die Anregung und der Empfang durch die Verschiebung der Larmorfrequenz mit dem Magnetfeld B0 auf unterschiedlichen Frequenzen erfolgt.

Gemäss einem Aspekt der Erfindung erfolgt dabei die Anregung der Kernspins mit einem Magnetfeld B0, das zu einer Larmorfrequenz führt, die in einem ISM-Band liegt. Die Definition dieser Bänder kann der Beschreibungseinleitung entnommen werden. In diesen ISM-Bändern sind höhere elektromagnetische Emissionen in die Umgebung zulässig, sodass die Grenzwerte, optional auch mit Hilfe aktiver Störunterdrückung durch destruktive Interferenz, auch ohne kostenintensive Schirmkabine eingehalten werden können.

Der Empfang wird hingegen durch Veränderung des homogenen Magnetfeldes B0 und damit verbundener Verschiebung der Larmorfrequenz in einen Frequenzbereich außerhalb des ISM-Bandes verschoben. Aufgrund der dort niedrigeren zulässigen Emissionswerte ist auch der Störpegel durch andere Quellen geringer und der Empfang des schwachen MR-Signals kann, gegebenenfalls auch wieder unter Zuhilfenahme von aktiver Störunterdrückung und anderen Entstörmaßnahmen, auch ohne Schirmkabine, mit ausreichendem Signal-zu-Rausch-Abstand für die Bildgebung erfolgen. Die Magnetsteuerung muss dabei in der Lage sein, das von den Modulationsspulen 70 erzeugte Magnetfeld ausreichend schnell zwischen den beiden Werten zu schalten bzw. zu steuern.

Gemäss einem anderen Aspekt der Erfindung wird beim Empfang der Magnetresonanzsignale das homogene Magnetfeld nicht konstant über den Empfangszeitraum in der Magnetfeldstärke verändert, sondern zeitlich variiert. Dies kann beispielsweise erfolgen, wenn die Magnetsteuerung 60 die Modulationsspulen 70 als Code mit einem zeitlich veränderlichen Wechselstrom ansteuert. Im einfachsten Fall kann das ein Sinussignal sein. Die Modulationsfrequenz ist dabei vergleichbar oder kürzer als der Kehrwert der Dauer des kontinuierlichen Empfangs des Magnetresonanzsignal bzw. eines Auslesezuges. Umgekehrt ist die Modulationsfrequenz wesentlich kleiner, beispielsweise um mehr als den Faktor 10, 100, 1000 oder 100000 als die Larmorfrequenz, sodass in Zusammenwirken mit der Amplitude eine Frequenzaufspreizung durch die Magnetfeldänderung und damit verbundene Änderung der Larmorfrequenz erfolgt, die kleiner ist als eine Empfangsbandbreite eines Empfängers für die Magnetresonanzsignale und größer als die Bandbreite eines Störers. Beispielsweise kann die erzielte Frequenzaufspreizung größer als 100 Hz, 1 kHz, 10 kHz, 100 kHz sein und kleiner als 1MHz, 5 Mhz oder 10 Mhz.

Anstelle des Sinussignals kann auch jedes andere zeitlich variierende Signal mit entsprechendem Frequenzbereich zur Modulation des Stromes durch die Magnetsteuerung 60 verwendet werden. Vorteilhaft sind beispielsweise auch Codes wie Pseudozufallsfolgen, die durch Autokorrelation erkannt und auch wieder demoduliert werden. Vorzugsweise weist der verwendete Code keine Frequenzanteile bei der Larmorfrequenz oder im Empfangsweg daraus abgeleiteter Signalfrequenzen auf.

Die Frequenzaufspreizung führt auf vorteilhafte Weise dazu, dass ein schmalbandiges Störsignal durch einen vorzugsweise adaptiven Filter (Notchfilter) ausgefiltert werden kann und dabei nur ein kleiner spektraler Anteil des aufgespreizten Magnetresonanzsignales verloren geht.

Ein Empfänger der Hochfrequenzeinheit 22 demoduliert das aufgespreizte Magnetresonanzsignal nach dem Filtern in Abhängigkeit von dem zur Aufspreizung verwendeten Code durch eine komplementäre Decodierung in einer Decodiervorrichtung. Bei einem sinusförmigen Strom als Code entspricht dies beispielsweise einer Demodulation eines frequenzmodulierten Signals. Bei komplexeren Codes erfolgt entsprechend eine Decodierung durch den Empfänger in Abhängigkeit von dem Code, beispielsweise bei Pseudozufallsfolgen durch Autokorrelation. So kann das ursprüngliche Magnetresonanzsignal wiederhergestellt werden und über die ermittelten Werte im k-Raum anschließend eine Bildrekonstruktion z.B. durch die Steuerung 23 erfolgen, um ein Bild auf einer Ausgabeeinheit darzustellen.

Es ist aber auch denkbar, dass die Decodierung je nach verwendetem Code direkt Teil der Erzeugung der Punkte im k-Raum ist und diese unmittelbar in Abhängigkeit von dem Code direkt aus dem empfangenen, frequenzaufgespreizten Magnetresonanzsignal erzeugt werden.

Dabei ist es auch möglich, beide Ausführungsformen der Erfindung zu kombinieren, um Störungen zu minimieren. Dazu wird von der Magnetsteuerung 60 neben einem konstanten Gleichstromanteil ein zeitlich variierender Strom mit einem Code zur Frequenzspreizung in die Modulationsspulen 70 eingespeist. Dadurch erfolgt auf vorteilhafte Weise die Verschiebung in ungestörtere Frequenzbereiche und gleichzeitig können schmalbandige Störer ausgefiltert werden.

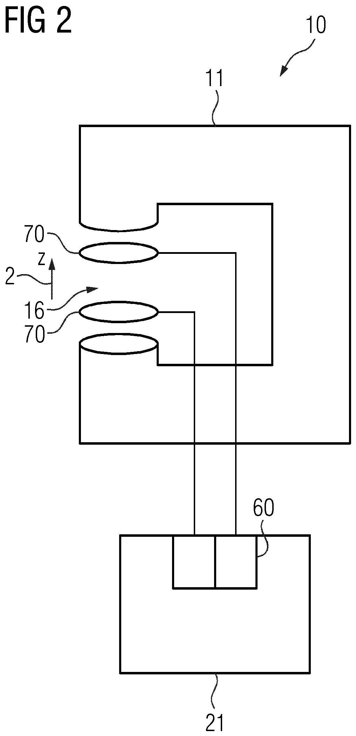

In Fig. 2 sind noch einmal die an der Erfindung unmittelbar beteiligten Komponenten des erfindungsgemäßen Magnetresonanztomographen dargestellt. Gleiche Referenzzeichen bezeichnen gleiche Gegenstände.

Beispielhaft für unterschiedliche Feldmagneten 11 ist hier ein Permanentmagnet angegeben. In dieser beispielhaften Ausführungsform dienen die Modulationsspulen 70 auch gleichzeitig als Gradientenspulen für die z-Richtung 2, indem die Magnetsteuerung 60 mit zwei Leistungsstufen zur unabhängigen Ansteuerung der einzelnen Spulen des Paares ausgelegt ist. So kann neben dem betragsmäßigen gleichen, aber mit umgekehrtem Vorzeichen in beiden Spulen fließenden Gradientenstrom auch ein in beiden Spulen gleicher Strom zur homogenen Magnetfeldverschiebung überlagert oder auch zeitlich getrennt angelegt werden.

Wegen der unterschiedlichen Anforderungen an den Frequenzgang, insbesondere bei der Frequenzspreizung, die Genauigkeit und die Homogenität können aber auch die zuvor beschriebenen separaten Modulationsspulen 70 vorteilhaft sein.

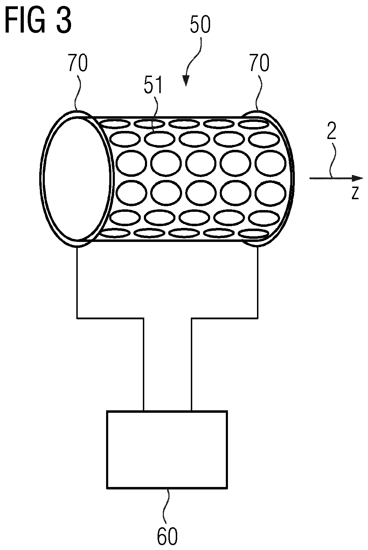

In Fig. 3 ist eine Ausführungsform dargestellt, bei der die Modulationsspulen 70 nicht eine homogene B0-Feldveränderung im gesamten Aufnahmebereich bewirken, sondern in einer Lokalspule nur in einem beschränkten Untersuchungsbereich. Beispielhaft ist in Fig. 3 eine Kniespule als Lokalspule 50 dargestellt, bei der das Knie außenumfänglich von Antennenspulen 51 zur Aufnahme des Magnetresonanzsignals umgeben ist. An den beiden Öffnungen der Kniespule sind in der Art eines Helmholtz-Paares die beiden Modulationsspulen 70 angeordnet, die wie beschrieben von der Magnetsteuerung 60 mit einem Strom zur Frequenzverschiebung und/oder Modulation mit einem versorgt werden. Bei einer Nutzung zur Bildgebung in dem erfindungsgemäßen Magnetresonanztomographen ist dabei die z-Achse der Kniespule mit der z-Achse des B0-Feldes des Feldmagneten 11 im Wesentlichen parallel ausgerichtet.

Das Prinzip der Kniespule in Fig. 3 ist erfindungsgemäß auch auf andere Lokalspulen anwendbar, wie z.B. Spine-Spule oder Kopfspule. Ist dabei eine Anordnung einer kreisförmigen Modulationsspule senkrecht zur z-Richtung nicht möglich, so kann das BO-Feld auch durch ein paar aus gegenüberliegenden, parallel zur z-Richtung ausgerichteten Schmetterlings- oder Sattelspulen in einem beschränkten Messvolumen homogen verändert werden.

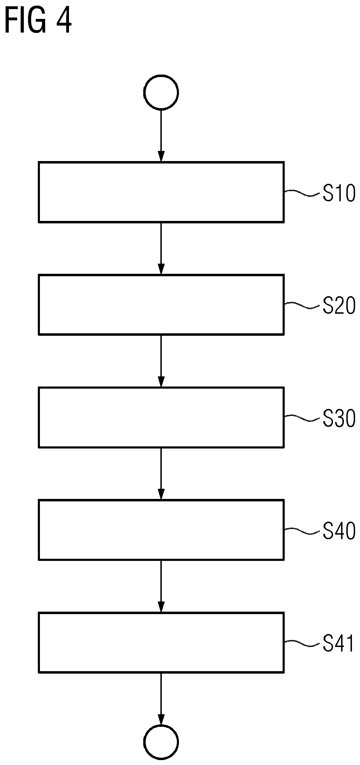

Fig.4 zeigt ein schematisches Ablaufdiagramm einer möglichen Ausführungsform des erfindungsgemäßen Verfahrens.

In einem Schritt S10 erzeuget die Magneteinheit 10 ein erstes homogenes Magnetfeld mit einer vorbestimmten Magnetfeldstärke B01 in einem Messvolumen. Das Magnetfeld kann beispielsweise durch Überlagerung eines statischen Feldes eines Feldmagneten 11 wie einem supraleitenden Magneten oder einem Permanentmagneten und eines zeitlich variablen homogenen Magnetfeldes erzeugt werden. Das zeitlich variable, in dem Messvolumen homogene Magnetfeld kann beispielsweise durch die beschriebenen Modulationsspulen 70 oder entsprechende Gradientenspulen 12 erzeugt werden, sofern diese mit dem entsprechenden Strom von der Magnetsteuerung versorgt werden, der ein gleichgerichtetes Magnetfeld in beiden Spulen erzeugt. Dies steht im Gegensatz zur Verwendung als Gradientenspulen 12, bei denen gerade durch entgegengesetzte Magnetfelder ein Magnetfeldgradient erzeugt werden soll, oder Shimspulen, die durch ein eigenes inhomogenes Feld Feldinhomogenitäten des Feldmagneten 11 kompensieren sollen. Das homogene BO-Feld kann dabei noch in Abhängigkeit von der Sequenz von einem Feldgradienten der Gradientenspulen 12 überlagert sein. Aus Sicht der Sequenz ist dabei das von Feldmagnet 11 und Modulationsspulen 70 erzeugte BO-Feld äquivalent zu einem entsprechend starken Magnetfeld eines Feldmagneten 11.

In einem weiteren Schritt S20 werden die zu erfassenden Kernspins mittels des magnetischen Wechselfeldes B1 durch einen Sender der Hochfrequenzeinheit 22 in Verbindung mit einer Antenne wie einer Körperspule 14 oder einer Lokalspule 50 in dem ersten homogenen Magnetfeld B01 in dem Messvolumen angeregt. Die Art der Anregungspulse ist dabei durch die verwendeten Sequenzen des Magnetresonanztomographen vorbestimmt.

In einem weiteren Schritt S30 erzeugt die Magnetsteuerung mit der Magneteinheit 10 wie bereits zu Schritt S10 beschrieben ein zweites homogenes Magnetfeld mit einer zweiten Magnetfeldstärke B02 in dem Messvolumen. Die Magnetfeldstärke B01 unterscheidet sich dabei von der Magnetfeldstärke B02. Es ist dabei insbesondere auch denkbar, dass bei einem von beiden Schritten S10 oder S30 das homogene Magnetfeld B0 allein von dem Feldmagneten 11 erzeugt wird, ohne durch eine Ansteuerung durch die Magnetsteuerung 60. Die unterschiedliche Magnetfeldstärke B01 bei S10 und B02 bei S30 wird dann durch die Ansteuerung im jeweils anderen Schritt bereitgestellt.

In einem Schritt S40 wird schließlich bei einer Magnetfeldstärke B02 das Magnetresonanzsignal der angeregten Kernspins von dem Empfänger des Magnetresonanztomographen 1 empfangen.

In einer bevorzugten Ausführungsform der erfindungsgemäßen Verfahrens weist dabei das erste homogene Magnetfeld während des Schrittes S20 des Anregens eine Magnetfeldstärke B01 auf, bei der eine Larmorfrequenz der zu untersuchenden Kernspins in einem ISM-Band liegt und das zweite homogene Magnetfeld während des Schrittes S40 des Empfangens eine Magnetfeldstärke, bei der eine Larmorfrequenz der zu untersuchenden Kernspins außerhalb des ISM-Bandes liegt. Mit anderen Worten, eine Anregung der Kernspins findet mit einem Anregungspuls statt, dessen Frequenz in einem ISM-Band liegt, während das Empfangen der Kernspins in einem Magnetfeld mit der Magnetfeldstärke B02 erfolgt, bei dem die Larmorfrequenz außerhalb des ISM-Bandes liegt. So unterliegen elektromagnetische Emissionen beim Anregen weniger strengen Vorschriften, während beim Empfangen die Magnetresonanzsignale in einem weniger gestörten Frequenzbereich liegen und der Signal-zu-Rauschabstand verbessert wird.

In einer denkbaren Ausführungsform des erfindungsgemäßen Verfahrens weist das zweite homogene Magnetfeld eine mit einem Code modulierte zeitlich veränderliche Magnetfeldstärke während des Schrittes S40 des Empfangens auf. Mit anderen Worten, die Magnetfeldstärke nimmt nicht nur einen zweiten vorbestimmten und von B01 verschiedenen Wert B02 während des Empfangens ein, sondern über den Zeitraum des Empfangens hinweg auch einen dritten unterschiedlichen oder viele unterschiedliche Werte. Die Magnetfeldstärke des in dem Messvolumen homogenen Magnetfeldes variiert über die Zeit hinweg und kann dabei zumindest auch eine echte Teilmenge des Zeitraums temporär den Wert B01 einnehmen. Durch die zeitlich veränderliche Magnetfeldstärke während des Empfangs wird das Magnetresonanzsignal frequenzmoduliert und im Frequenzbereich aufgespreizt. So ist es auch denkbar, durch einen mit einem Code modulierten Strom von der Magnetsteuerung 60 durch die Modulationsspule 70 eine Modulation des Magnetresonanzsignales mit einem Code vorzunehmen.

In einem weiteren Schritt S41 dieser Ausführungsform des erfindungsgemäßen Verfahrens ermittelt der Magnetresonanztomograph mittels einer Decodiervorrichtung einen Messpunkt im k-Raum aus dem empfangenen frequenzgespreizten Magnetresonanzsignal in Abhängigkeit von dem Code. Bei einem einfachen Code wie einem Sinusverlauf des Stromes ist es dabei denkbar, zunächst durch Demodulation in der Decodiervorrichtung das ungespreizte Magnetresonanzsignal zu rekonstruieren und anschließen mit den bekannten Mitteln die k-Raum-Punkte zu bestimmen. Bei komplexeren Codes ist es aber auch denkbar, durch veränderte Bildrekonstruktionsverfahren die k-Raum-Punkte und daraus Bildpunkte unmittelbar, ohne den Zwischenschritt des Rekonstruierens des ursprünglichen Magnetresonanzsignals, zu ermitteln.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Magnetresonanztomograph, wobei der Magnetresonanztomograph (1) eine Magneteinheit (10) mit einer Magnetsteuerung (60) aufweist, die ausgelegt ist, in einem Messvolumen ein homogenes Magnetfeld B0 mit einer zwischen einem ersten vorbestimmten Wert der Magnetfeldstärke (B01) bei einem Anregen von Kernspins und einem zweiten vorbestimmten Wert der Magnetfeldstärke (B02) bei einem Empfangen von Magnetresonanzsignalen veränderbaren Magnetfeldstärke in einer kurzen vorbestimmten Zeit von dem Magnetresonanztomographen (1) gesteuert zu ändern,
**dadurch gekennzeichnet, dass**
eine Larmorfrequenz eines zu untersuchenden Kerns bei dem ersten Wert der Magnetfeldstärke (B01) in einem ISM-Band liegt und bei dem zweiten Wert der Magnetfeldstärke (B02) außerhalb des ISM-Bandes liegt.

2. Magnetresonanztomograph, wobei der Magnetresonanztomograph (1) eine Magneteinheit (10) mit einer Magnetsteuerung (60) aufweist, die ausgelegt ist, in einem Messvolumen ein homogenes Magnetfeld B0 mit einer zwischen einem ersten vorbestimmten Wert der Magnetfeldstärke (B01) bei einem Anregen von Kernspins und einem zweiten vorbestimmten anderen Wert der Magnetfeldstärke (B02) bei einem Empfangen von Magnetresonanzsignalen veränderbaren Magnetfeldstärke in einer kurzen vorbestimmten Zeit von dem Magnetresonanztomographen (1) gesteuert zu ändern,
**dadurch gekennzeichnet, dass**
die Magnetsteuerung (60) ausgelegt ist, das homogene Magnetfeld mit der zweiten Magnetfeldstärke (B02) während des Empfangens von Magnetresonanzsignalen in der Magnetfeldstärke mit einem Code zu modulieren um das Magnetresonanzsignal im Frequenzraum aufzuspreizen.

3. Magnetresonanztomograph nach einem der vorhergehenden Ansprüche, wobei der Magnetresonanztomograph (1) einen Sensor zum Empfang eines Störsignals und eine aktive Störunterdrückung zum Reduzieren eines Störsignalanteils in einem empfangenen Magnetresonanzsignal in Abhängigkeit von dem empfangenen Störsignal aufweist.

4. Magnetresonanztomograph nach einem der vorhergehenden Ansprüche, wobei die Magneteinheit (10) einen supraleitenden Feldmagneten zum Erzeugen eines statischen Magnetfeldanteils aufweist und eine resistive Spulenwicklung zum Erzeugen eines dynamischen Magnetfeldanteils zur Modulation der Magnetfeldstärke aufweist.

5. Magnetresonanztomograph nach Anspruch 2, wobei der Magnetresonanztomograph (1) einen Empfänger mit einer Decodiervorrichtung aufweist, wobei die Decodiervorrichtung ausgelegt ist, aus dem durch die Modulation des Magnetfeldes B0 mit dem Code verursachte Frequenzaufspreizung aufgespreizten Magnetresonanzsignal Messpunkte im k-Raum in Abhängigkeit von dem Code zu bestimmen.

6. Verfahren zum Betrieb eines Magnetresonanztomographen (1), wobei der Magnetresonanztomograph eine Steuerung 23, eine Magneteinheit (10) zum Erzeugen eines veränderlichen homogenen Magnetfeldes B0 und eine Magnetsteuerung (60) aufweist,
einen Sender und eine Sendeantenne zum Erzeugen eines hochfrequenten magnetischen Wechselfeldes B1 zum Anregen von zu untersuchenden Kernspins,
eine Empfangsantenne und einen Empfänger zum Empfangen eines Magnetresonanzsignals der Kernspins,
wobei das Verfahren die Schritte aufweist:
(S10) Erzeugen eines ersten Magnetfeldes B0 mit einer ersten vorbestimmten Magnetfeldstärke (B01) durch die Magneteinrichtung (10) in einem Messvolumen;
(S20) Anregen der Kernspins mittels des magnetischen Wechselfeldes B1 durch den Sender in dem ersten homogenen Magnetfeld;
(S30) Erzeugen eines zweiten homogenen Magnetfeldes mit einer vorbestimmten Magnetfeldstärke (B02) durch die Magneteinrichtung (10) in dem Messvolumen;
(S40) Empfangen der Magnetresonanzsignale aus dem Messvolumen mittels des Empfängers, wobei sich das erste homogene Magnetfeld und das zweite homogene Magnetfeld in der Magnetfeldstärke unterscheiden,
**dadurch gekennzeichnet, dass**
das erste homogene Magnetfeld während des Schrittes (S20) des Anregens eine Magnetfeldstärke (B01) aufweist, bei der eine Larmorfrequenz der zu untersuchenden Kernspins in einem ISM-Band liegt und das zweite homogene Magnetfeld während des Schrittes (S40) des Empfangens eine Magnetfeldstärke (B02) aufweist, bei der eine Larmorfrequenz der zu untersuchenden Kernspins außerhalb des ISM-Bandes liegt.

7. Verfahren zum Betrieb eines Magnetresonanztomographen (1), wobei der Magnetresonanztomograph eine Steuerung 23, eine Magneteinheit (10) zum Erzeugen eines veränderlichen homogenen Magnetfeldes B0 und eine Magnetsteuerung (60) aufweist,
einen Sender und eine Sendeantenne zum Erzeugen eines hochfrequenten magnetischen Wechselfeldes B1 zum Anregen von zu untersuchenden Kernspins,
eine Empfangsantenne und einen Empfänger zum Empfangen eines Magnetresonanzsignals der Kernspins,
wobei das Verfahren die Schritte aufweist:
(S10) Erzeugen eines ersten Magnetfeldes B0 mit einer ersten vorbestimmten Magnetfeldstärke (B01) durch die Magneteinrichtung (10) in einem Messvolumen;
(S20) Anregen der Kernspins mittels des magnetischen Wechselfeldes B1 durch den Sender in dem ersten homogenen Magnetfeld;
(S30) Erzeugen eines zweiten homogenen Magnetfeldes mit einer vorbestimmten Magnetfeldstärke (B02) durch die Magneteinrichtung (10) in dem Messvolumen;
(S40) Empfangen der Magnetresonanzsignale aus dem Messvolumen mittels des Empfängers, wobei sich das erste homogene Magnetfeld und das zweite homogene Magnetfeld in der Magnetfeldstärke unterscheiden,
**dadurch gekennzeichnet, dass**
das zweite homogene Magnetfeld eine mit einem Code modulierte zeitlich veränderliche Magnetfeldstärke während des Schrittes (S40) des Empfangens aufweist.

8. Verfahren nach Anspruch 7, wobei der Magnetresonanztomograph eine Decodiervorrichtung aufweist, wobei die Decodiervorrichtung in einem Schritt (S41) aus dem durch die Modulation des Magnetfeldes B0 mit dem Code verursachte Frequenzaufspreizung aufgespreizten Magnetresonanzsignal Messpunkte im k-Raum in Abhängigkeit von dem Code bestimmt.

9. Computerprogrammprodukt, welches direkt in einen Prozessor einer programmierbaren Steuerung (23) eines Magnetresonanztomographen nach einem der Ansprüche 1 bis 5 ladbar ist, mit Programmcode-Mitteln, um alle Schritte eines Verfahrens nach einem der Ansprüche 6 bis 8 auszuführen, wenn das Programmprodukt auf der Steuerung (23) ausgeführt wird.

10. Computerlesbares Speichermedium mit darauf gespeicherten elektronisch lesbaren Steuerinformationen, welche derart ausgestaltet sind, dass sie bei Verwendung des Speichermediums in einer Steuerung (23) eines Magnetresonanztomographen (1) nach einem der Ansprüche 1 bis 5 das Verfahren nach einem der Ansprüche 6 bis 8 durchführen.

## Claims

1. Magnetic resonance tomography system, wherein the magnetic resonance tomography system (1) has a magnetic unit (10) with a magnetic controller (60), which is configured to change a homogeneous magnetic field B0 with a magnetic field strength, which can vary between a first predetermined value of the magnetic field strength (B01) on exciting nuclear spins and a second predetermined value of the magnetic field strength (B02) on receiving magnetic resonance signals, in a measuring volume in a short predetermined time, controlled by the magnetic resonance tomography system (1),
**characterised in that**
a Larmor frequency of a nucleus to be examined lies in an ISM band in the case of the first value of the magnetic field strength (B01) and lies outside of the ISM band in the case of the second value of the magnetic field strength (B02).

2. Magnetic resonance tomography system, wherein the magnetic resonance tomography system (1) has a magnetic unit (10) with a magnetic controller (60), which is configured to change a homogeneous magnetic field B0 with a magnetic field strength, which can vary between a first predetermined value of the magnetic field strength (B01) on exciting nuclear spins and a second predetermined other value of the magnetic field strength (B02) on receiving magnetic resonance signals, in a measuring volume in a short predetermined time, controlled by the magnetic resonance tomography system (1),
**characterised in that**
the magnetic controller (60) is configured to modulate the homogeneous magnetic field with the second magnetic field strength (B02) during the receiving of magnetic resonance signals in the magnetic field strength with a code in order to spread the magnetic resonance signal in the frequency domain.

3. Magnetic resonance tomography system according to one of the preceding claims, wherein the magnetic resonance tomography system (1) has a sensor to receive an interference signal and an active interference suppression for reducing an interference signal component in a received magnetic resonance signal as a function of the received interference signal.

4. Magnetic resonance tomography system according to one of the preceding claims, wherein the magnetic unit (10) has a superconducting field magnet for generating a static magnetic field component and a resistive coil winding for generating a dynamic magnetic field component for the modulation of the magnetic field strength.

5. Magnetic resonance tomography system according to claim 2, wherein the magnetic resonance tomography system (1) has a receiver with a decoding apparatus, wherein the decoding apparatus is configured to determine from the spread magnetic resonance signal frequency spreading caused by the modulation of the magnetic field B0 with the code measuring points in the k-space as a function of the code.

6. Method for the operation of a magnetic resonance tomography system (1), wherein the magnetic resonance tomography system has a controller 23, a magnetic unit (10) for generating a variable homogeneous magnetic field B0 and a magnetic controller (60),
a transmitter and a transmit antenna for generating a radio frequency magnetic alternating field B1 for exciting nuclear spins to be examined,
a receive antenna and a receiver for receiving a magnetic resonance signal of the nuclear spins,
wherein the method has the following steps:
(S10) generating a first magnetic field B0 with a first predetermined magnetic field strength (B01) in a measuring volume by way of the magnetic facility (10);
(S20) exciting the nuclear spins by means of the magnetic alternating field B1 by way of the transmitter in the first homogeneous magnetic field;
(S30) generating a second homogeneous magnetic field with a predetermined magnetic field strength (B02) in the measuring volume by way of the magnetic facility (10);
(S40) receiving the magnetic resonance signals from the measuring volume by means of the receiver, wherein the first homogeneous magnetic field and the second homogeneous magnetic field differ in magnetic field strength,
**characterised in that**
during the step (S20) of exciting, the first homogeneous magnetic field has a magnetic field strength (B01) at which a Larmor frequency of the nuclear spins to be examined lies in an ISM band and during the step (S40) of receiving, the second homogeneous magnetic field has a magnetic field strength (B02) at which a Larmor frequency of the nuclear spins to be examined lies outside the ISM band.

7. Method for the operation of a magnetic resonance tomography system (1), wherein the magnetic resonance tomography system has a controller 23, a magnetic unit (10) for generating a variable homogeneous magnetic field B0 and a magnetic controller (60),
a transmitter and a transmit antenna for generating a radio frequency magnetic alternating field B1 for exciting nuclear spins to be examined,
a receive antenna and a receiver for receiving a magnetic resonance signal of the nuclear spins,
wherein the method has the following steps:
(S10) generating a first magnetic field B0 with a first predetermined magnetic field strength (B01) in a measuring volume by way of the magnetic facility (10);
(S20) exciting the nuclear spins by means of the magnetic alternating field B1 by way of the transmitter in the first homogeneous magnetic field;
(S30) generating a second homogeneous magnetic field with a predetermined magnetic field strength (B02) in the measuring volume by way of the magnetic facility (10);
(S40) receiving the magnetic resonance signals from the measuring volume by means of the receiver, wherein the first homogeneous magnetic field and the second homogeneous magnetic field differ in magnetic field strength,
**characterised in that**
the second homogeneous magnetic field has a magnetic field strength which varies over time and is modulated with a code during the step (S40) of receiving.

8. Method according to claim 7, wherein the magnetic resonance tomography system has a decoding apparatus, wherein in a step (S41), the decoding apparatus determines from the spread magnetic resonance signal frequency spreading caused by the modulation of the magnetic field B0 with the code measuring points in the k-space as a function of the code.

9. Computer program product, which can be loaded directly into a processor of a programmable controller (23) of a magnetic resonance tomography system according to one of claims 1 to 5, with program code means in order to carry out all steps of a method according to one of claims 6 to 8 when the program product is run on the controller (23).

10. Computer-readable storage medium with electronically readable control information stored thereon, which can be configured in such a way that it carries out the method according to one of claims 6 to 8 when the storage medium is used in a controller (23) of a magnetic resonance tomography system (1) according to one of claims 1 to 5.

## Revendications

1. Tomodensitomètre à résonnance magnétique, dans lequel le tomodensitomètre (1) à résonnance magnétique a une unité (10) magnétique ayant une commande (60) magnétique, qui est conçue pour modifier, de manière commandée, par le tomodensitomètre (1) à résonnance magnétique, dans un temps bref défini à l'avance, dans un volume de mesure, un champ B0 magnétique homogène ayant une intensité de champ magnétique pouvant être modifiée entre une première valeur définie à l'avance de l'intensité (B01) du champ magnétique, lors d'une excitation de spins de noyau, et une deuxième valeur définie à l'avance de l'intensité (B02) du champ magnétique, lors d'une réception de signaux de résonnance magnétique,
**caractérisé en ce que**
une fréquence de Larmor d'un noyau à étudier est, à la première valeur de l'intensité (B01) du champ magnétique, est dans une bande ISM et, à la deuxième valeur de l'intensité (B02) du champ magnétique, est à l'extérieur de la bande ISM.

2. Tomodensitomètre à résonnance magnétique, dans lequel le tomodensitomètre (1) à résonnance magnétique a une unité (10) magnétique ayant une commande (60) magnétique, qui est conçue pour modifier, de manière commandée, par le tomodensitomètre (1) à résonnance magnétique, dans un temps bref défini à l'avance, dans un volume de mesure, un champ B0 magnétique homogène ayant une intensité de champ magnétique pouvant être modifiée entre une première valeur définie à l'avance de l'intensité (B01) du champ magnétique, lors d'une excitation de spins de noyau, et une autre deuxième valeur définie à l'avance de l'intensité (B02) du champ magnétique, lors d'une réception de signaux de résonnance magnétique,
**caractérisé en ce que**
la commande (60) magnétique est conçue pour moduler, par un code dans l'intensité du champ magnétique, le champ magnétique homogène ayant la deuxième intensité (B02) du champ magnétique, pendant la réception des signaux de résonnance magnétique, afin d'étaler le signal de résonnance magnétique dans l'espace de fréquence.

3. Tomodensitomètre à résonnance magnétique suivant l'une des revendications précédentes, dans lequel le tomodensitomètre (1) à résonnance magnétique a un capteur de réception d'un signal parasite et un antiparasitage actif de réduction d'une proportion de signal parasite dans un signal de résonnance magnétique reçu en fonction du signal parasite reçu.

4. Tomodensitomètre à résonnance magnétique suivant l'une des revendications précédentes, dans lequel l'unité (10) magnétique a, pour la modulation de l'intensité du champ magnétique, un aimant de champ supraconducteur pour la production d'une proportion statique de champ magnétique et un enroulement de bobine résistif pour la production d'une proportion de champ magnétique dynamique.

5. Tomodensitomètre à résonnance magnétique suivant la revendication 2, dans lequel le tomodensitomètre (1) à résonnance magnétique a un récepteur ayant un dispositif de décodage, dans lequel le dispositif de décodage est conçu pour déterminer, en fonction du code, des points de mesure dans l'espace k, à partir du signal de résonnance magnétique étalé par l'étalement de fréquence provoqué par la modulation du champ B0 magnétique par le code.

6. Procédé pour faire fonctionner un tomodensitomètre (1) à résonnance magnétique, dans lequel le tomodensitomètre à résonnance magnétique a une commande 23, une unité (10) magnétique de production d'un champ B0 magnétique homogène variable et une commande (60) magnétique,
un émetteur et une antenne d'émission pour la production d'un champ B1 alternatif magnétique à haute fréquence d'excitation de spins de noyau à étudier,
une antenne de réception et un récepteur pour la réception d'un signal de résonnance magnétique des spins de noyau,
dans lequel le procédé a les stades :
(S10) production d'un premier champ B0 magnétique ayant une première intensité (B01) de champ magnétique définie à l'avance par le dispositif (10) magnétique dans un volume de mesure ;
(S20) excitation des spins de noyau au moyen du champ B1 alternatif magnétique par l'émetteur dans le premier champ magnétique homogène ;
(S30) production d'un deuxième champ magnétique homogène ayant une intensité (B02) de champ magnétique définie à l'avance par le dispositif (10) magnétique dans le volume de mesure ;
(S40) réception des signaux de résonnance magnétique, à partir du volume de mesure, au moyen du récepteur, dans lequel le premier champ magnétique homogène et le deuxième champ magnétique homogène ont des intensités de champ magnétique différentes,
**caractérisé en ce que**
le premier champ magnétique homogène a, pendant le stade (S20) de l'excitation, une intensité (B01) de champ magnétique pour laquelle une fréquence de Larmor des spins de noyau à étudier est dans une bande ISM, et le deuxième champ magnétique homogène a, pendant le stade (S40) de la réception d'une intensité (B02) de champ magnétique, pour laquelle une fréquence de Larmor des spins de noyau à étudier est à l'extérieur de la bande ISM.

7. Procédé pour faire fonctionner un tomodensitomètre (1) à résonnance magnétique, dans lequel le tomodensitomètre à résonnance magnétique à une commande 23, une unité (10) magnétique de production d'un champ B0 magnétique homogène variable et une commande (60) magnétique,
un émetteur et une antenne d'émission pour la production d'un champ B1 alternatif magnétique à haute fréquence d'excitation de spins de noyau à étudier,
une antenne de réception et un récepteur pour la réception d'un signal de résonnance magnétique des spins de noyau,
dans lequel le procédé a les stades :
(S10) production d'un premier champ B0 magnétique ayant une première intensité (B01) de champ magnétique définie à l'avance par le dispositif (10) magnétique dans un volume de mesure ;
(S20) excitation des spins de noyau au moyen du champ B1 alternatif magnétique par l'émetteur dans le premier champ magnétique homogène ;
(S30) production d'un deuxième champ magnétique homogène ayant une intensité (B02) de champ magnétique définie à l'avance par le dispositif (10) magnétique dans le volume de mesure ;
(S40) réception des signaux de résonnance magnétique, à partir du volume de mesure, au moyen du récepteur, dans lequel le premier champ magnétique homogène et le deuxième champ magnétique homogène ont des intensités de champ magnétique différentes,
**caractérisé en ce que**
le deuxième champ magnétique homogène a, pendant le stade (S40) de la réception, une intensité de champ magnétique variable dans le temps modulée par un code.

8. Procédé suivant la revendication 7, dans lequel le tomodensitomètre à résonnance magnétique a un dispositif de décodage, dans lequel le dispositif de décodage détermine, en fonction du code, dans un stade (S41), des points de mesure dans l'espace k, à partir du signal de résonnance magnétique étalé en modulation de fréquence provoquée par la modulation du champ B0 magnétique par le code.

9. Produit de programme d'ordinateur, qui peut être chargé directement dans un processeur d'une commande (23) programmable d'un tomodensitomètre à résonnance magnétique suivant l'une des revendications 1 à 5, comprenant des moyens de code de programme pour effectuer tous les stades d'un procédé suivant l'une des revendications 6 à 8, lorsque le produit de programme est réalisé sur la commande (23).

10. Support de mémoire, déchiffrable par ordinateur, sur lequel sont mises en mémoire des informations de commande déchiffrables électroniquement, qui sont conformées de manière à ce qu'elles effectuent, lors de l'utilisation du support de mémoire dans une commande (23) d'un tomodensitomètre (1) à résonnance magnétique suivant l'une des revendications 1 à 5, le procédé suivant l'une des revendications 6 à 8.
